# EUROPEAN PATENT SPECIFICATION

(11) **EP 2 539 944 B1**
(45) Date of publication and mention of the grant of the patent: **30.04.2014**
(21) Application number: 11706349.5
(22) Date of filing: 30.01.2011
(51) Int. Cl.: H01L 35/00, F24B 1/20, F24B 5/02, H02M 3/155

(54) **THERMO-ELECTRIC GENERATOR SYSTEM**
Thermoelektrogeneratorsystem
Système générateur thermo-électrique

(30) Priority: 25.02.2010 EP 10154619
(43) Date of publication of application: 02.01.2013
(73) Proprietor: Koninklijke Philips N.V., 5656 AE Eindhoven (NL)
(72) Inventor: KAMPING, Wiecher Ferdinand, NL-5656AE Eindhoven (NL)
(74) Representative: Coops, Peter
(86) International application number: PCT/IB2011/050403
(87) International publication number: WO 2011/104645

(56) References cited:
- EP-A2- 1 564 822
- JP-A- 2007 005 371
- JP-A- 2008 071 879
- US-A- 3 384 806
- US-A1- 2003 223 919
- US-A1- 2009 025 703
- US-A1- 2009 250 091
- US-A1- 2009 301 539
- YU C ET AL: "Thermoelectric automotive waste heat energy recovery using maximum power point tracking", ENERGY CONVERSION AND MANAGEMENT, ELSEVIER SCIENCE PUBLISHERS, OXFORD, GB, vol. 50, no. 6, 1 June 2009 (2009-06-01), pages 1506-1512, XP026044521, ISSN: 0196-8904, DOI: 10.1016/J.ENCONMAN.2009.02.015 [retrieved on 2009-04-01]
- NAGAYOSHI H ET AL: "Comparison of maximum power point control methods for thermoelectric power generator", THERMOELECTRICS, 2002. PROCEEDINGS ICT '02. TWENTY-FIRST INTERNATIONAL CONFERENCE ON AUG. 25-29, 2002, PISCATAWAY, NJ, USA,IEEE, 25 August 2002 (2002-08-25), pages 450-453, XP010637523, ISBN: 978-0-7803-7683-0

## Description

### FIELD OF THE INVENTION

The invention relates to a thermoelectric generator system comprising a thermoelectric element which is able to convert a temperature difference between a first active surface of the element and a second active surface of the element into electricity for generating electrical power from thermal energy during use of the system; and, a control unit for controlling the electrical power generated by the element in correspondence to an existing power demand which is imposed on the thermoelectric element during use.

### BACKGROUND OF THE INVENTION

A thermoelectric generator system is known from US 2009/0025703 A1 (Van Der Sluis et al.). US 2009/0025703 A1 discloses a solid fuel, portable stove having a thermoelectric element which provides power to a fan and a rechargeable battery. The fan is configured for forcing air into a combustion chamber of the stove. The fan forces air into a combustion chamber of the stove. A thermoelectric element provides power to the fan. It has a first active surface in close proximity to the combustion chamber and a second active surface which receives a cooling draught from the fan. Being equipped with forced air supply, the stove, also known as a "woodstove", provides for a high temperature of combustion and a fuel-efficient and clean burning process. The stove has an electronic control unit and a controller configured to operate the stove in four possible modes. The electronic control unit is adapted to automatically sequence through each of the four modes in turn, according to the sensed operating conditions, e.g. heat of the fire.

In a first mode, labeled the 'start-up' mode, power from the rechargeable battery is used to drive the fan even when no (or insufficient) power is available from the thermoelectric element to drive the fan. In this way, the fuel being burnt in the combustion chamber is enabled to reach optimum high temperatures very quickly, considerably reducing smoke and other polluting emissions during the start up phase of the stove.

A second mode, labeled 'charge' mode, is triggered when the temperature reaches an appropriate level. In the second mode, the fuel in the combustion chamber is burning at sufficient temperature that the thermoelectric element is capable of providing more than sufficient power to the fan for maintaining adequate forced convection to the combustion chamber, and thus also provides sufficient power to recharge the battery.

A third mode, labeled 'normal' mode, is triggered when the battery returns to a condition of full charge. In the third mode, the fuel in the combustion chamber is burning at sufficient temperature that the thermoelectric element is capable of providing at least sufficient power to the fan for maintaining adequate forced convection to the combustion chamber.

A fourth mode, labeled'cool down' mode, is triggered when the temperature falls, e.g. due to exhaustion of the fuel in the combustion chamber. In the fourth mode, the fan no longer needs to maintain combustion which has finished. In this mode, the battery is isolated and any power available from the thermoelectric element is directed to the fan simply to accelerate cooling of the stove as a whole, but without discharging the battery. This prevents residual heat from the combustion chamber from building up within the housing and potentially damaging any one or more of the thermoelectric element, the fan and the electronic control circuit.

Stoves of this kind are among others intended for use on camping grounds, in natural scenery or for use in developing countries where the cooking process is frequently taking place indoors. It is of utmost importance that the combustion process is and stays clean and efficient. A long lifetime and reliable functioning of the thermoelectric element are of utmost importance.

### SUMMARY OF THE INVENTION

It is an object of the present invention to further improve the lifetime and reliability of thermoelectric generator systems.

This object is realized by the thermoelectric generator system according to the invention in that the control unit comprises means to operate the thermoelectric element for an existing power demand being less than the maximum amount of power of the thermoelectric element at one of two possible operation points providing the same power and each defining a combination of a current and an impedance, which one operation point has the highest electric current of the two possible operation points.

This technical feature of operating the thermoelectric element at a higher electrical current than strictly required for the existing power demand is rather unnatural when the thermoelectric element is conceived as a conventional power source, i.e. other than a thermoelectric such as a battery. For a conventional power source, such as a battery, it is unfavorable from an energetic point of view, to have a higher current run through the power source than required, because of the internal resistance of such a conventional power source. Contrary to conventional power sources, a thermoelectric element can be advantageously and surprisingly operated at a set point of increased electrical current. An aspect of the invention is that the insight is appreciated that a thermoelectric element behaves different than an battery from an energetic point of view, which difference is economically used to the benefit of an increase in lifetime.

In each of the modes of operation of the device of US 2009/0025703 A1 an existing power demand is imposed to the thermoelectric element. In the first mode the power demand imposed on the thermoelectric element is zero and the power which is needed to drive the fan is taken from the battery. In the second mode the power demand imposed to the thermoelectric element is intended to power the fan for maintaining adequate forced convection to the combustion chamber, and for recharge of the battery. In the third mode the battery is fully charged and the imposed power demand is reduced to powering the fan for maintaining adequate forced convection to the combustion chamber. In the fourth mode the power demand imposed to the thermoelectric element is directed to power supply of the fan to accelerate cooling of the stove as a whole, but without discharging the battery.

In several modes of operation, for example when the batteries of the stove are fully charged, the thermoelectric element does not have to generate its maximum amount of power which would be attainable under the existing conditions such as temperature of the fire and temperature difference between the active surfaces of the thermoelectric element. In such a point of operation, i.e. when the existing power demand imposed on the thermoelectric element is less than the maximum power which can be generated by the element under the existing conditions, the control unit limits the power output of the thermoelectric element to the actual or existing power demand. In state of the art devices limitation of power output is accomplished by limiting the current that runs through the power source, i.e. the thermoelectric element, to an electrical current which is minimally required to meet the existing power demand imposed on the thermoelectric.

The invention lies in the notion that a power demand which is below the maximum attainable power output of the thermoelectric element can be achieved by reducing the power output of the thermoelectric generator system, without necessarily reducing the electrical current through the thermoelectric element to a minimally required electrical current. By operating the thermoelectric element at an electrical current which exceeds an electrical current which is minimally required to meet the existing power demand, the thermal resistance of the thermoelectric element is decreased. The thermal resistance of a thermoelectric element (measured in K·W⁻¹ or in °C/W)) expresses how much its first active surface and its second active surface differ in temperature when the quantity of heat that passes per unit of time through said thermoelectric element equals one Watt. By the decrease in thermal resistance the temperature balance across the thermoelectric element is changed such that the temperature of the hottest surface is decreased. The thermoelectric element is normally arranged in close proximity to a heat source such as the combustion chamber of the stove of US 2009/0025703 A1. The temperature of its first surface roughly varies between room temperature in unused state and the relatively high operating temperature such as the temperature near the combustion chamber of the stove during cooking. This results to a heavy thermal load and to high expansion of the thermoelectric element when brought from a cold state to its operating temperature. Specifically the side of the thermoelectric element receiving heat, i.e. the first active surface, is exposed to this high thermal load. It has been found that by operating the thermoelectric element according to the invention a decrease in maximum temperature of the first surface in the order of magnitude of 10 to 20 degrees can be achieved. Already such a temperature reduction of the first active surface leads to a significant increase of lifetime of the thermoelectric element.

In an advantageous embodiment of the generator system according to the invention the control unit includes a current source to drive the thermoelectric element at an electrical current which exceeds an electrical current which is minimally required to meet the existing power demand imposed on the thermoelectric element.

Thermoelectric elements such as disclosed in US 2009/0025703 A1 can be used in so-called thermoelectric "generation" mode. In this generation mode heat is received by one side of the element, viz. the first active surface, and rejected or disposed of at the second active or cold surface of the element, the first and second active surfaces usually being opposite sides of the element. The heat flow through the element goes together with a temperature difference between the first active surface and the second active surface, the temperature of the first active surface being higher than the temperature of the second active surface. In the generation mode an electrical current is produced, which is dependent on the temperature difference between the first active and second active surface. In this generation mode, a temperature gradient is maintained across the element and the heat flux which passes through the module is converted into electrical power. This is known as Seebeck effect. In the generation mode electrical energy is generated by the element and the generated electrical energy can be used to feed other components of the system such as for example a fan, a battery, a lighting arrangement or a combination thereof. Thermoelectric elements can also be used in so-called thermoelectric "cooling" mode. In this cooling mode an electric current is applied to a thermoelectric element. In cooling mode, heat is pumped from one side or junction (the cold side or cold junction) to another side or junction (the hot side or hot junction). The cold junction will drop below ambient temperature provided heat is removed from the hot side. The temperature gradient will vary according to the magnitude of current applied. In cooling mode, an electrical current is supplied to the element which results to one side of the element becoming cold. This is known as Peltier effect. In the cooling mode electrical energy is consumed by the element. By actively feeding an electrical current into the thermoelectric element by the current source the Peltier effect can be used as an emergency measure in case the first active surface, i.e. the surface which reaches the highest temperature, gets overheated. By the provision of a current source it is possible to operate the thermoelectric element in a forced cooling mode of itself.

In an advantageous embodiment of the generator system according to the invention the control unit comprises means to amend an output impedance to obtain the impedance of the one operation point having the highest electric current and the lowest impedance of the two possible operation points.

During use, the thermoelectric element is connected to an output impedance constituted by the control unit and a load such as a fan and/or a battery and/or other devices which are connected to electric terminals of the thermoelectric element. In a first extreme situation wherein the electric terminals of the thermoelectric element are directly connected such that a short circuit is obtained, the output impedance is zero and the voltage drop across the output impedance is zero. The current though the output impedance is limited by the internal resistance of the thermoelectric element. As a result the power which is dissipated and delivered to the output impedance is zero in the first extreme situation. In a second extreme situation the output impedance of the thermoelectric element is infinite, i.e. the terminals are not connected, such that the current which flows through the element is zero while the voltage across the infinite output impedance is the ideal voltage or open source voltage of the thermoelectric element. As a result the power which is dissipated and delivered to the output impedance is also zero in the second extreme situation. In a normal situation the output impedance is neither zero nor infinite but is a value intermediate between zero and infinity. In a normal situation power is delivered to the output impedance because both an electrical current through the output impedance and a voltage over the output impedance are present. When the output impedance of the thermoelectric element is continuously decreased from infinity to zero, the current through the thermoelectric element increases from zero to a short-circuit value, while the power delivered to the output impedance initially increases from zero at infinite output impedance, i.e. the second extreme situation, to a maximum attainable power value at an output impedance which is intermediate between zero and infinity and subsequently decreases to zero power again, i.e. at zero output impedance. Hence, the relation between the output impedance of the thermoelectric element and the power delivered to the output impedance can be represented by a graph with a rising and a falling flank. At the rising flank the power increases with increasing impedance. At the falling flank the power decreases with increasing impedance. A possible power value between zero power and the maximum attainable power value is available both at the rising flank and at the falling flank. The preferred operating range for the thermoelectric element is on the rising flank, because at the rising flank the output impedances are lower than at the falling flank; this brings the opportunity to run the thermoelectric element at a higher electrical current than at the falling flank, which is advantageous for lifetime. This advantage is obtained in a very cost-effective way since no additional components or circuitry is needed; only the set-point of existing circuitry needs to be changed.

An advantageous embodiment of the generator system according to the invention has a temperature sensor for measuring the temperature of the first active surface, wherein a signal of the temperature sensor is receivable by the control unit, wherein the electrical current through the thermoelectric element is adjustable on the basis of the signal from the temperature sensor.

By the feedback on the temperature of the first active surface it is possible to keep control over the thermal load of the thermoelectric element. As a result excessive thermal loads can be avoided in a robust and reliable way and more independently of the variations in the thermal load which are due to different fuels or to variation in operating conditions.

### BRIEF DESCRIPTION OF THE DRAWINGS

In the following preferred embodiments of the invention will be described, by way of example only, and with reference to the drawings in which:
Fig.1 shows a block diagram which illustrates a method according to an embodiment of the invention;
Fig.2 illustrates a functional diagram of a thermoelectric generator system according to an embodiment of the invention;
Fig. 3 illustrates an equivalent circuit diagram of a thermoelectric generator system according to a further embodiment of the invention;
Fig. 4 shows a plot which illustrates how the thermal resistance of a thermoelectric element depends upon the electrical current flowing through it;
Fig. 5 shows a plot which illustrates the different in temperature between the hot and cold sides of a thermoelectric element as a function of heat resistance;
Fig. 6 shows a plot which illustrates two different operating points which both supply 1 watt of power for an embodiment of a thermoelectric generator system according to the invention; and
Fig. 7 shows experimental validation illustrating the reduction in temperature of the first side of a thermoelectric element according to an embodiment of the invention.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

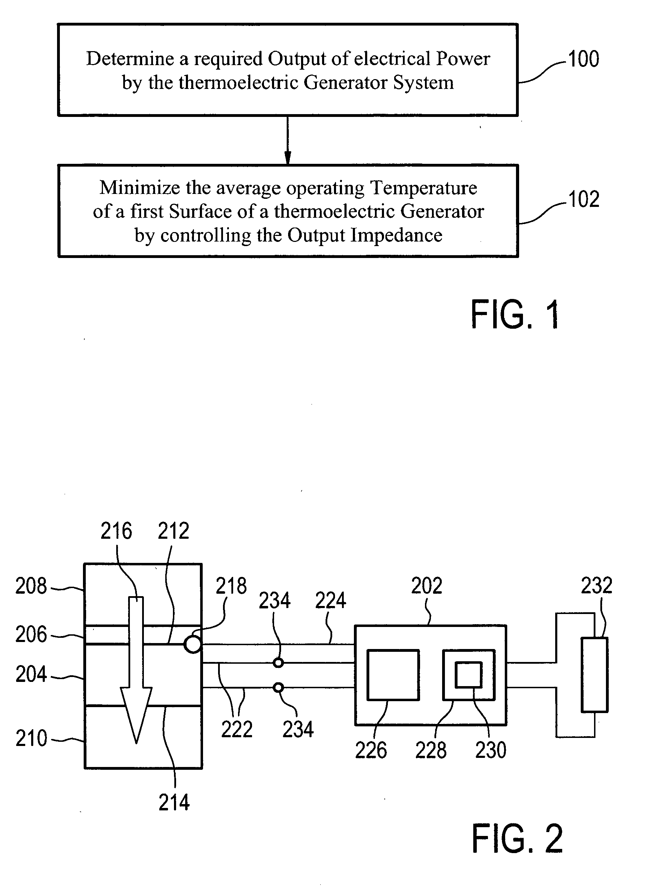

Fig. 1 shows an embodiment of a method according to the invention. The method may be implemented as instructions for execution by a processor of a control unit. In step 100 a required output of electrical power is determined by the thermoelectric generator system. This may be performed by the control unit. The required output of electrical power is an amount of electrical power output by the thermoelectric element to supply the electrical load with electrical power. The required output of electrical power may also be referred to as a predetermined output of electrical power. For instance the thermoelectric generator system is used to charge a battery used for driving a fan which controls the oxygen in a wood burner or wood stove, the amount of electrical power is decreased when the battery is fully charged. So in this case the thermoelectric generator system may have several different states. For instance when the battery is charging the electrical power is optimized. However when the battery is fully charged the output of electrical power is reduced. In step 102 the average operating temperature of a heat receiving surface of the thermoelectric element is minimized by controlling the current through the thermoelectric element, e.g., by adjusting the impedance of the electrical circuit including the electrical active material of the Peltier or by adjusting the voltage over the Peltier by an additional current supply. The heat receiving surface is s surface which receives heat from the heater. Heat from the heater may conducted to the heat receiving surface by conductive heat transfer, radiative heat transfer, and/or convective heat transfer.

Fig. 2 shows an embodiment of a thermoelectric generator system according to an embodiment of the invention. The thermoelectric generator system comprises a control unit 202. The control unit 202 is adapted for regulating the current flow through a thermoelectric element 204. The thermoelectric element 204 has a heat receiving surface 212 and a cooled surface 214. The heat receiving surface 212 is in contact with a heat conducting element 206. The heat conducting element 206 is also in contact with a heater 208. The cooled surface 214 is in contact with a cooler 210. There is a heat flow indicated by the arrow labeled 216 from the heater 208 through the heat conducting element 206 and the thermoelectric element 204 to the cooler 210, such as a component which is exposed to a draft of cooling air generated by a fan. Also shown is a temperature sensor 218 that is in contact with the heat receiving surface 212 of the thermoelectric element 204. There is an electrical connection 222 between the thermoelectric element 204 and the control unit 202. Also shown in this figure is output terminal 234 on electrical connection 222. The output impedance of the thermoelectric element 204 may be the output impedance across output terminal 234. Shown in this embodiment is a processor 226. The processor may be a computer, an embedded system, a microcontroller, or any processor adapted for executing machine readable instructions. There is also a memory 228 adapted for storing computer memory and the contents of the memory are readable by the processor 226. In the memory 228 is a computer program 230 which comprises machine readable instructions. When the program 230 is executed by the processor 228 of the control unit 202 performs an embodiment of a method according to the invention. Shown is an electrical load 232 which is connected to the control unit 202.

Depending upon the electrical power which is delivered to the load 232, the control unit 202 regulates the current generated by the thermoelectric element 204. The computer program 230 may have algorithms for adaptively adjusting the current flow through the thermoelectric element 204 using a feedback system. Alternatively a computer program 230 may also contain a lookup table for operating the thermoelectric generator system. The control unit 202 does not need to be controlled by a processor 226. Alternatively an analog circuit can be constructed which can be used to regulate the current through the thermoelectric element 204.

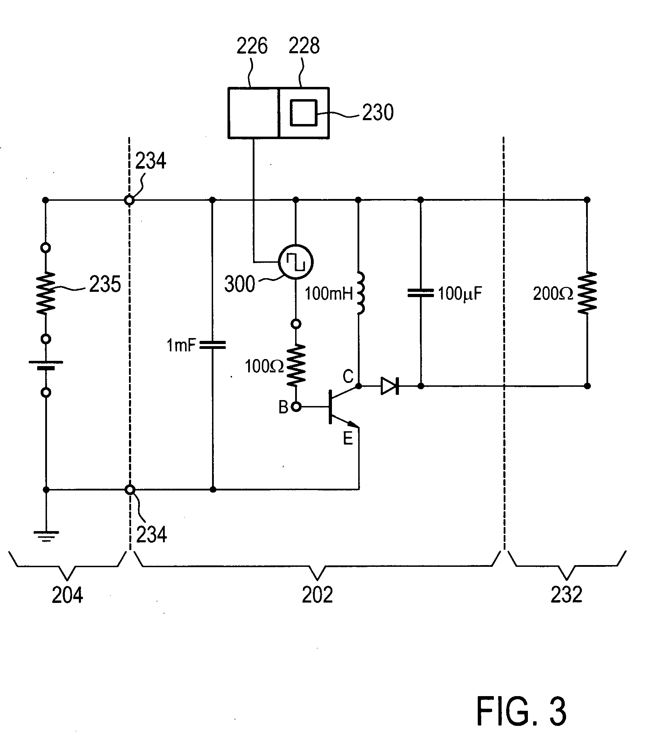

Fig. 3 shows an example of a circuit which may be used to illustrate the functioning of a embodiment of the thermoelectric generator system according to the invention. There is a Thevenin equivalent circuit which electrically represents the thermoelectric element 204. There is a resistance 232 which is representative of the electrical load, e.g. a fan which provides cooling air as mentioned above. The electrical load is connected to the control unit 202. At the connection between the equivalent circuit 204 and the control unit 202 is output terminal 234. Output terminal 234 is the output of the equivalent circuit 204 representing the Thermoelectric element. The output impedance of the equivalent circuit 204 representing the thermoelectric element may be measured across output terminal 234. In this example, the output impedance of the equivalent circuit 204 is a resistance 235.

In this example a pulse generator 300 has its duty cycle controlled by a processor 226. The duty cycle of the pulse generator 300 controls the output voltage of the control unit 202. If the output voltage is less than the maximum, there are always two duty cycles at which the output voltage and the current are the same. At the higher of the two duty cycle values, the current through the Peltier or thermoelectric element 204 will be the largest. A Peltier is a type of thermoelectric element. Herein, comments directed towards a Peltier are applicable to other types of thermoelectric elements unless noted. When the current through the thermoelectric element 204 is the largest the output impedance at the terminal 234 is its lowest.

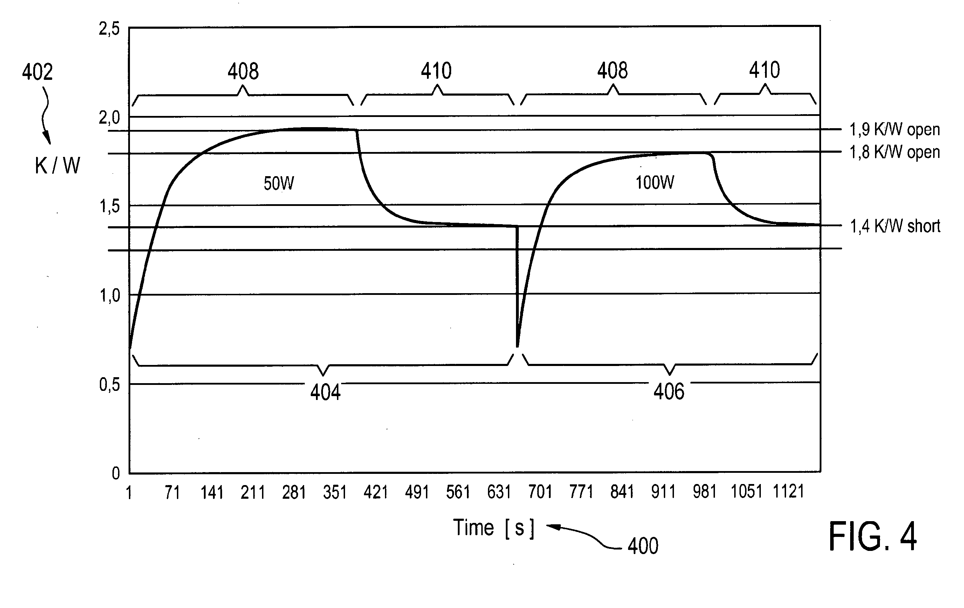

Fig. 4 illustrates how the thermal resistance of a of a type TEP1-12235-2.0H Peltier depends upon the current that runs through it. The x-axis 400 is the time and is shown in seconds. The thermal resistance is the y-axis and is labeled 402. Two separate experiments are shown. The first experiment is shown in the section of the curve labeled 404: 50 watts is passed through the thermoelectric element. The second experiment is shown in the section of curve labeled 406: 100 watts is passed through the thermoelectric element. Each of these two experiments is subdivided into time periods. The first time period 408 is where the thermoelectric element is an open circuit or has an infinite load. The second time period 410 is when the Peltier or thermoelectric element is shorted. There is no load across the Peltier at this time.

It can be seen here that the thermal resistance is highest when the Peltier or thermoelectric element is open or has an infinite load across it. By reducing the impedance of a load or shorting the Peltier the thermal resistance decreases. Thermal resistance may also be referred to herein as heat resistance. This will result in an increased heat flow if the heating and cooling reservoirs are kept at the same temperatures. If a conducting element is located between the first or hot side of the thermoelectric element and the heat source, the temperature of the hot or first side of the Peltier will decrease. This figure illustrates how the thermal resistance of a thermoelectric element (or Peltier) depends on the current that runs through it.

The external resistance was changed from an open connection to a short (infinite and 0 resistance.) Later an optimal load was applied: The external resistance or load of the Peltier, Rext, being equal to the internal resistance of the Peltier, Rint. From this measurement it follows that the thermal resistance of a type TEP1-12235-2.0H Peltier is to a first order estimation: 1.8-0.4*(Rint/(Rint + Rext)).

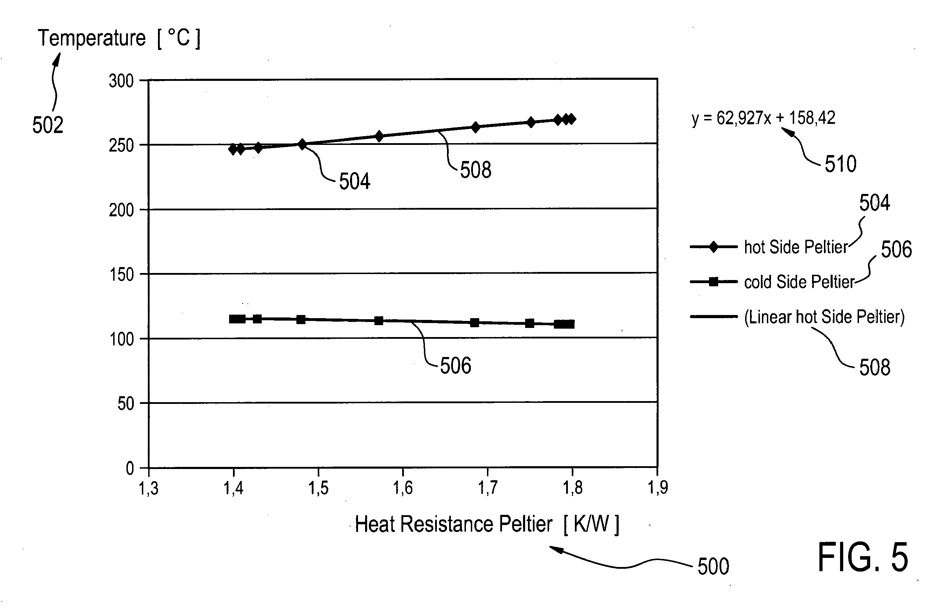

Fig. 5 shows an example of the temperature of the hot and cold sides of a Peltier element for changes in the heat resistance of the Peltier unit. For this experiment the cooking stove as is disclosed in Van Der Sluis et al. was modeled using a linear model. The x-axis 500 shows the heat resistance of the Peltier and is expressed in terms of K/watts. Y-axis is the temperature 502 in degrees Celsius. The curve 504 shows the temperature of the hot or first side of the Peltier element. The curve labeled 506 shows the temperature of the cold or the second side of the Peltier element 506. Line 508 is a linear fit to the hot side measurements 504. The equation 510 shows this linear fit. This figure demonstrates that the temperature of the hot side of the Peltier 504 can be controlled by controlling the heat resistance 500. The heat resistance can be controlled by controlling the current through the Peltier as was illustrated in Fig. 4.

When the batteries of the stove are fully charged, the Peltier does not have to generate its maximum amount of power. During charging the load is optimal (external resistance equal to the internal resistance). When less power is needed the external resistance is raised so that less current runs through the system and less power is generated. This is the way that all power sources are generally used (for instance a battery: if you want less power, you increase the load resistance).

Embodiments of the invention may have the aspect that it is advantageous to reduce the electrical power by lowering the external resistance, generating more current, but less power. In this case, more power is dissipated inside the Peltier.

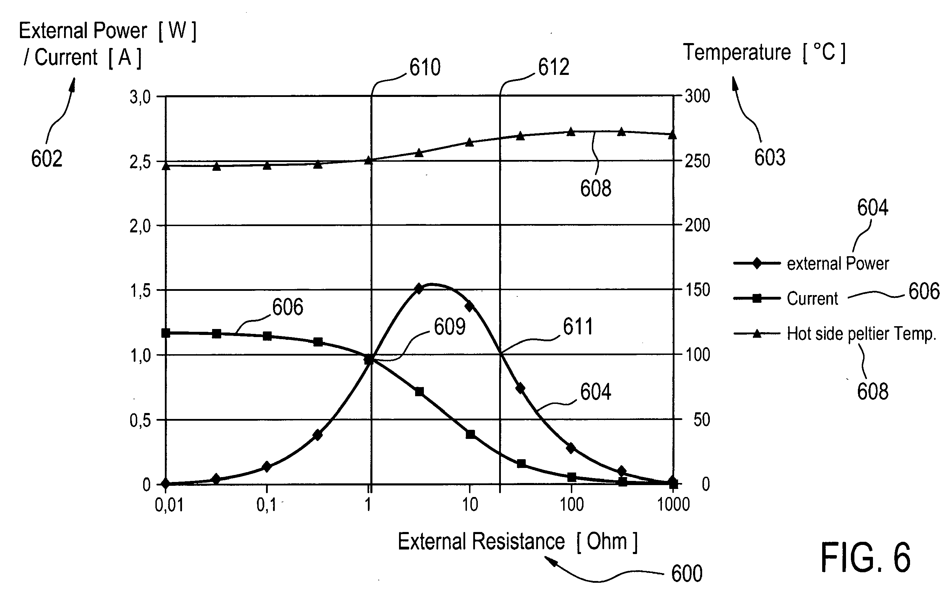

Fig. 6 illustrates how there are two different operating points 609 and 611 indicated by lines 610 and 612 which both supply 1 watt of power with different temperatures at the hot or first side of a Peltier element. Line 610 passes through low temperature operating point 609 and line 612 passes through high temperature operating point 611. For this example the previously mentioned linear model is used again. The x-axis 600 shows the external resistance, Rext, in ohms. The external resistance may also be referred to as the electrical load. The y-axis 602 shows the external power in watts divided by current in amps 602. The y-axis also shows the temperature in degrees Celsius 604. The curve labeled 604 shows the external power supplied by the thermoelectric generator system of the cooking stove. The curve labeled 604 has a bell shape because for low external resistances a larger portion of the electrical energy is dissipated within the thermo electric generator. For larger external resistances, the large resistance limits the current flow. This reduced current limits the transfer of power to the electrical load.

The curve 606 shows the current through the Peltier element. The curve 608 shows the hot or first side temperature of the Peltier element. As the external resistance is increased the external power 604 increases and then decreases again. The current 606 is maximum when the external resistance is its least and then decreases as external resistance increases. The hot or first side of the Peltier temperature increases as the external resistance increases. Because the external power 604 increases and then decreases again there are two points at which the external power is 1 watt. These are labeled points 610 and 612. At 610, the current 606 is higher and the temperature 608 is lower than at 612. Fig. 6 illustrates how it is possible to have two operating points 609, 612 at the cross-section of vertical lines 610 and 612 with curve 604 for the same external power per unit of current. This also illustrates how the hot or first side of the Peltier could be operated at a reduced temperature. Operating the Peltier element at the point 610 reduces the temperature on the hotter first side of the Peltier and therefore increases the useful lifespan of the Peltier element. This reduces the likelihood that someone will need to replace the Peltier element.

At the upper operating point the (simulated) temperature is approximately 268°C. At the lower operating point the temperature is approximately 250°C. To fully appreciate the invention it should be mentioned here that the lifetime changes rather steep or rapidly as a function of operation temperature. Hence, such a difference can have a lot of effect on the lifetime of the Peltier and it is therefore desirable to have the software operate at the lower operating point.

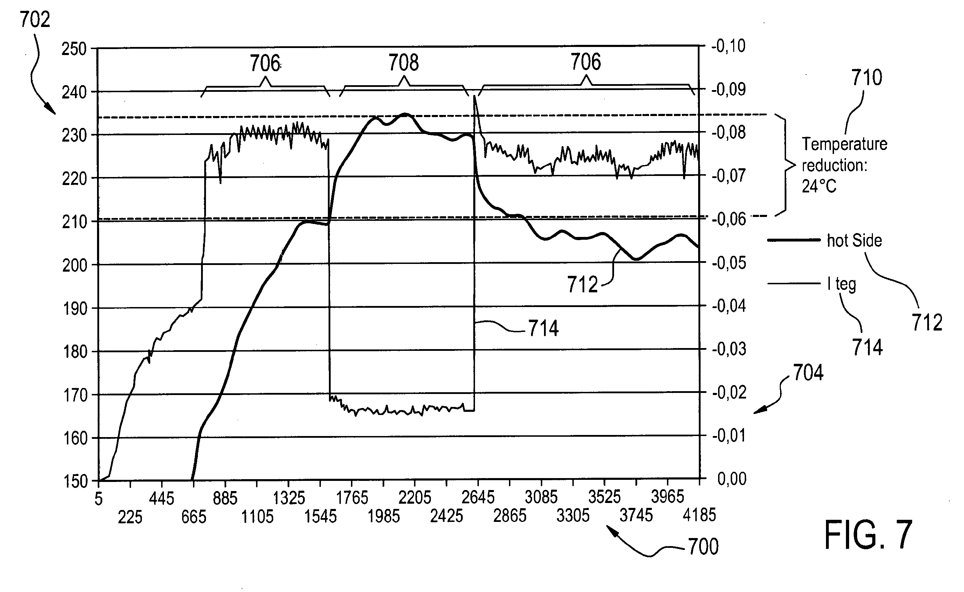

Fig. 7 shows measurements using an embodiment of a method applied to the cooking stove described in Van Der Sluis et al. Time is indicated in seconds on the x-axis 700. A vertical scale 702 is used to indicate temperature in degrees Celsius. A further vertical scale 704 is used to indicate electrical current in Amperes. The curve 712 shows the temperature of the hot or first side of the Peltier element. Values related to curve 712 are indicated by the temperature scale at the left of the figure. The curve 714 shows the current through the Peltier element. During the time period labeled 706 the Peltier is operated in a high current mode as can be concluded from Fig. 7 where current values of around 0.08 Amperes were applied. During the time period 708 the Peltier is operated in a low current operating point (current values of approximately 0.015 Amperes). When the current is higher (period 706) the temperature is relatively low (210 degrees Celsius) compared to period 708 where the current is low and the temperature is relatively high (234 degrees Celsius). The temperature difference is thus approximately 24 degrees Celsius. This temperature difference is indicated by two dotted lines. This illustrates how the maximum operating temperature of the hot or first side of a thermoelectric element can be reduced.

While the invention has been illustrated and described in detail in the drawings and foregoing description, such illustration and description are to be considered illustrative or exemplary and not restrictive; the invention is not limited to the disclosed embodiments.

For example, it is possible to operate the invention in an embodiment wherein the aspect of portability is not present, for instance in a stove or a grilling device which is positioned stationary and which is not intended or specifically designed to be portable. However, the thermoelectric technology may bring special advantages when applied in portable devices because of compactness and energy efficiency. It is also possible that the thermoelectric generator system comprises a heat source such as a radioactive element comprising a radioisotope, a combustion engine, an exhaust pipe, a surface heated by solar illumination, a surface heated by thermal radiation, a surface heated by hot gasses, or a surface heated by mechanical friction.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

### LIST OF REFERENCE NUMERALS

- 200: Thermoelectric generator system
- 202: Control unit
- 204: Thermoelectic generator
- 206: Heat conducting element
- 208: Heater
- 210: Cooler
- 212: Heat receiving surface
- 214: Cooled surface
- 216: Direction of heat flow
- 218: Temperature sensor
- 220: Electrical connection between thermoelectric element and control unit
- 224: Connection between temperature sensor and control unit
- 226: Processor
- 228: Memory
- 230: Program
- 232: Electrical load
- 234: Output terminal
- 235: Resistance
- 300: Pulse generator
- 400: Time
- 402: Heat resistance of Peltier
- 404: 50 Watts of heat through Peltier
- 406: 100 Watts of heat through Peltier
- 408: Infinite load across Peltier
- 410: Peltier shorted
- 500: Heat resistance (K/W)
- 502: Temperature in degrees Celsius
- 504: Hot or first side of peltier temperature
- 506: Cold or second side of Peltier temperature
- 508: Linear fit to data in line 504
- 510: Equation showing linear fit
- 600: External resistance in Ohms
- 602: External power in watts divided by current in amps
- 603: Temperature in degrees Celsius
- 604: External power
- 606: Current through Peltier
- 608: Temperature of hot of first side of Peltier
- 609: Low temperature operating point
- 610: Line indicating low temperature operating point
- 611: High temperature operating point
- 612: Line indicating high temperature operating point
- 700: Time in seconds
- 702: Temperature in degrees Celsius
- 704: Current in amps
- 706: High current operating point
- 708: Low current operating point
- 710: Temperature difference
- 712: Temperature of hot or first side of peltier
- 714: Current through Peltier

## Claims

1. A thermoelectric generator system comprising:
- a thermoelectric element (204) which is able to convert a temperature difference between a first active surface (212) of the element and a second active surface of the element into electricity for generating electrical power from thermal energy during use of the system; and,
- a control unit (202) for controlling the electrical power generated by the element in correspondence to an existing power demand which is imposed on the thermoelectric element during use,
**characterized in that** the control unit (202) comprises means to operate the thermoelectric element for an existing power demand being less than the maximum amount of power of the thermoelectric element at one of two possible operation points providing the same power and each defining a combination of a current and an impedance, which one operation point has the highest electric current of the two possible operation points.

2. A thermoelectric generator system according to claim 1, wherein the control unit includes a current source to drive the thermoelectric element at an electrical current which exceeds an electrical current which is minimally required to meet the existing power demand imposed on the thermoelectric element.

3. A thermoelectric generator system according to claim 1, wherein the control unit comprises means to amend an output impedance to obtain the impedance of the one operation point having the highest electric current and the lowest impedance of the two possible operation points.

4. A thermoelectric generator system according to claim 1, comprising a temperature sensor (218) for measuring the temperature of the first active surface, wherein the signal of the temperature sensor is receivable by the control unit, wherein the electrical current through the thermoelectric element is adjustable on the basis of the signal from the temperature sensor.

5. A thermoelectric generator system according to claim 1, arranged to be used as a solid fuel stove by having a
- combustion chamber for containing fuel for combustion for providing thermal energy during use of the stove,
- a load (232) comprising a fan having an electric motor and an impeller configured to force air into the combustion chamber,
- wherein the second active surface is arranged to receive a cooling draught from the fan during use of the stove, wherein the first active surface is arranged between the second active surface and the combustion chamber.

6. A thermoelectric generator system according to claim 5, wherein the load (232) comprises a rechargeable battery.

7. A thermoelectric generator system according to claim 5 which is portable.

8. A thermoelectric generator system according to claim 2, comprising a heat conducting element (206) for conducting heat between the combustion chamber and the first active surface.

9. The thermoelectric generator system according to claim 1, wherein said control unit comprises one or more processors (226), memory (228), and one or more programs (230); wherein the one or more programs are stored in the memory and configured to be executed by the one or more processors, said one or more programs comprising:
- instructions for determining (100) a required output of electrical power by said thermoelectric generator system; and
- instructions for minimizing (102) said operating temperature by controlling said current to the current of the one operation point having the highest electric current of the two possible operation points.

10. A thermoelectric generator system according to claim 1, wherein the generator system includes a heat source (208) for providing thermal energy during use of said thermoelectric generator system to the first active surface (212) of the thermoelectric element;

## Patentansprüche

1. Thermoelektrogeneratorsystem, das Folgendes umfasst:
- ein thermoelektrisches Element (204), das imstande ist, einen Temperaturunterschied zwischen einer ersten aktiven Oberfläche (212) des Elementes und einer zweiten aktiven Oberflache des Elementes in Elektrizität umzuwandeln. Und zwar zum erzeugen elektrischer Leistung aus thermischer Energie bei Verwendung des Systems; und
- eine Steuereinheit (202) zur Steuerung der von dem Element erzeugten elektrischen Energie. Und zwar entsprechend einem bestehenden Leistungsbedarfs, der dem thermischen Element bei Verwendung desselben auferlegt wird,
**dadurch gekennzeichnet, dass** die Steuereinheit (202) Mittel zum Betreiben des thermoelektrischen Elementes für einen bestehenden Leistungsbedarf aufweist, der kleiner ist als die maximale Leistungsmenge des thermoelektrischen Elementes an einer von zwei möglichen Betriebsstellen, welche die gleiche Leistung liefern und je eine Kombination eines Stroms und einer Impedanz definieren, wobei diese Betriebsstelle den höheren elektrischen Strom der zwei möglichen Betriebsstellen führt.

2. Thermoelektrogeneratorsystem nach Anspruch 1, wobei die Steuereinheit eine Stromquelle umfasst zum Betreiben des thermoelektrischen Elementes mit einem elektrischen Strom, der höher ist als ein elektrischer Strom, der zum Erfüllen des dem thermoelektrischen Element auferlegten, bestehenden Leistungsbedarfs minimal erforderlich ist.

3. Thermoelektrogeneratorsystem nach Anspruch 1, wobei die Steuereinheit Mittel zum Verbessern einer Ausgangsimpedanz aufweist, und zwar zum Erhalten der Impedanz der einen Betriebsstelle mit dem höheren elektrischen Strom und der niedrigeren Impedanz der zwei möglichen Betriebsstellen.

4. Thermoelektrogeneratorsystem nach Anspruch 1, mit einem Temperatursensor (218) zum Messen der Temperatur der ersten aktiven Oberfläche, wobei das Signal des Temperatursensors in der Steuereinheit empfangen werden kann, wobei der elektrische Strom durch das thermoelektrische Element auf Basis des Signals von dem Temperatursensor einstellbar ist.

5. Thermoelektrogeneratorsystem nach Anspruch 1, dazu vorgesehen, als Festbrennstoffherd verwendet zu werden, wobei dieser Herd Folgendes umfasst:
- eine Brennkammer zum Enthalten von Brennstoff zum Schaffen thermischer Energie während der Verwendung des Herds,
- eine Last (232) mit einem Lüfter mit einem Elektromotor und einem Flügelrad, vorgesehen zum Treiben von Luft in die Brennkammer,
- wobei die zweite aktive Oberfläche dazu vorgesehen ist, bei Verwendung des Herds von dem Flügelrad einen kühlenden Luftzug zu empfangen, wobei die erste aktive oberflache zwischen der zweiten aktiven Oberfläche und der Brennkammer vorgesehen ist.

6. Thermoelektrogeneratorsystem nach Anspruch 5, wobei die Last (232) eine aufladbare Batterie aufweist.

7. Thermoelektrogeneratorsystem nach Anspruch 5, das tragbar ist.

8. Thermoelektrogeneratorsystem nach Anspruch 2, mit einem Wärmeleitelement (206) zum Leiten von wärme zwischen der Brennkammer und der ersten aktiven Oberfläche.

9. Thermoelektrogeneratorsystem nach Anspruch 1, wobei die genannte Steuereinheit einen oder mehrere Prozessoren (226), einen Speicher (228) und ein oder mehrere Programme (230) aufweist, wobei das eine Programm oder mehrere Programme in dem Speicher gespeichert und derart konfiguriert ist bzw. sind, dass es bzw. sie von dem einen Prozessor oder von mehreren Prozessoren durchgeführt werden, wobei das genannte eine Programm bzw. die Programme Folgendes umfassen:
- Instruktionen zum Bestimmen (100) einer erforderlichen Lieferung elektroscher Leistung durch das genannte Thermoelektrogeneratorsystem; und
- Instruktionen zur Minimierung (102) der genannten Betriebstemperatur durch Steuerung des genannten Stroms zu dem Strom der einen Betriebsstelle mit dem höheren elektrischen Strom der beiden möglichen Betriebsstellen.

10. Thermoelektrogeneratorsystem nach Anspruch 1, wobei das Generatorsystem eine Wärmequelle (208) aufweist, und zwar zum Liefern thermischer Energie während der Verwendung des genannten Thermoelektrogeneratorsystems zu der ersten aktiven Oberfläche (212) des thermoelektrischen Elements.

## Revendications

1. Système de générateur thermoélectrique comprenant :
- un élément thermoélectrique (204) qui est capable de convertir une différence de température entre une première surface active (212) de l'élément et une seconde surface active de l'élément en électricité afin de générer une puissance électrique à partir d'énergie thermique lors de l'utilisation du système ; et
- une unité de commande (202) qui est destinée à commander la puissance électrique étant générée par l'élément en correspondance avec une demande de puissance existante qui est imposée à l'élément thermoélectrique au cours de l'utilisation ;
**caractérisé en ce que** l'unité de commande (202) comprend des moyens pour exploiter l'élément thermoélectrique pour une demande de puissance existante qui est inférieure à la quantité maximum de puissance de l'élément thermoélectrique à l'endroit d'un de deux points de fonctionnement possibles fournissant la même puissance et chacun définissant une combinaison d'un courant et d'une impédance, lequel un point de fonctionnement présente le courant électrique le plus élevé des deux points de fonctionnement possibles.

2. Système de générateur thermoélectrique selon la revendication 1, dans lequel l'unité de commande comprend une source de courant qui est destinée à exciter l'élément thermoélectrique à un courant électrique qui dépasse un courant électrique qui est au minimum requis pour satisfaire à la demande de puissance existante étant imposée à l'élément thermoélectrique.

3. Système de générateur thermoélectrique selon la revendication 1, dans lequel l'unité de commande comprend des moyens pour modifier une impédance de sortie afin d'obtenir l'impédance de l'un point de fonctionnement ayant le courant électrique le plus élevé et l'impédance la plus basse des deux points de fonctionnement possibles.

4. Système de générateur thermoélectrique selon la revendication 1, comprenant un capteur de température (218) pour mesurer la température de la première surface active, dans lequel le signal du capteur de température est recevable par l'unité de commande dans laquelle le courant électrique à travers l'élément thermoélectrique est réglable sur la base du signal en provenance du capteur de température.

5. Système de générateur thermoélectrique selon la revendication 1 qui est agencé de manière à être utilisé en tant qu'un poêle à combustible solide en ayant :
- une chambre de combustion qui est destiné à contenir du combustible pour la combustion afin de fournir de l'énergie thermique lors de l'utilisation du poêle ;
- une charge (232) comprenant un ventilateur ayant un moteur électrique et un rotor qui est configuré de manière à forcer de l'air dans la chambre de combustion ;
- dans lequel la seconde surface active est agencée de manière à recevoir un tirage de refroidissement en provenance du ventilateur lors de l'utilisation du poêle dans lequel la première surface active est agencée entre la seconde surface active et la chambre de combustion.

6. Système de générateur thermoélectrique selon la revendication 5, dans lequel la charge (232) comprend une batterie rechargeable.

7. Système de générateur thermoélectrique selon la revendication 5 qui est portable.

8. Système de générateur thermoélectrique selon la revendication 2, comprenant un élément de conduction de chaleur (206) qui est destiné à conduire de la chaleur entre la chambre de combustion et la première surface active.

9. Système de générateur thermoélectrique selon la revendication 1, dans lequel ladite unité de commande comprend un ou plusieurs processeurs (226), une mémoire (228) et un ou plusieurs programmes (230) dans laquelle l'un ou les plusieurs programmes sont stockés dans la mémoire et sont configurés de manière à être exécutés par l'un ou les plusieurs processeurs, ledit un ou lesdits plusieurs programmes comprenant :
- des instructions qui sont destinées à déterminer (100) une sortie requise de puissance électrique par ledit système de générateur thermoélectrique ; et
- des instructions qui sont destinées à minimiser (102) ladite température de fonctionnement en commandant ledit courant au courant de l'un point de fonctionnement ayant le courant électrique le plus élevé des deux points de fonctionnement possibles.

10. Système de générateur thermoélectrique selon la revendication 1, dans lequel le système de générateur comprend une source thermique (208) qui est destinée à fournir de l'énergie thermique lors de l'utilisation dudit système de générateur thermoélectrique à la première surface active (212) de l'élément thermoélectrique.
